# EUROPEAN PATENT APPLICATION

(11) **EP 3 731 413 A1**
(43) Date of publication of application: **28.10.2020**
(21) Application number: 19171257.9
(22) Date of filing: 26.04.2019
(51) Int. Cl.: H03K 17/082

(54) **GATE DRIVER CIRCUIT AND METHOD FOR DRIVING A GATE OF A FIELD-EFFECT TRANSISTOR**

(71) Applicant: Infineon Technologies AG, 85579 Neubiberg (DE)
(72) Inventor: ARENS, Andre, 59602 Rüthen (DE)
(74) Representative: Westphal, Mussgnug & Partner Patentanwälte mbB

(57) **Abstract**

A gate driver circuit is described that comprises a field-effect transistor having a gate electrode, a drain electrode, and a source electrode; a gate driver configured to provide a first voltage to the gate electrode of the field-effect transistor in accordance with an input signal; and a protection circuit coupled to the drain electrode and to the gate electrode and configured to apply a second voltage to the gate electrode when a source-drain voltage of the field-effect transistor exceeds a threshold voltage.

## Description

### TECHNICAL FIELD

This application relates to the field of power semiconductor circuits and modules.

### BACKGROUND

Power transistors are key components in power electronics. They are usually controlled by so-called gate driver circuits, which are configured to switch them on and off. However, in particular during short-circuits or during switch-on, the transistors can be subjected to overcurrents that can cause damage to the transistors. In current and future chip technologies, it may be important to reduce the maximum short-circuit time allowed in order to avoid such damages as much as possible and thus to efficiently protect the device. This is usually done by using an external desaturation detection circuit or an overcurrent detection circuit capable of sensing the output current of the transistor and comparing it to a threshold value. While these methods are well adapted to limiting short circuit times in insulated gate bipolar transistors (IGBT), they may be too slow for protecting silicon carbide metal-oxide-semiconductor field-effect transistors (SiC MOSFETs) at least in some applications. The peak of the short-circuit currents for SiC MOSFETs is indeed much higher than for IGBTs since SiC MOSFETs usually have a much lower resistance. Consequently, damages may occur even during very short short-circuit times. It may be thus very important to quickly reduce the magnitude of the short-circuit currents in order to protect SiC MOSFETs efficiently.

A first approach to this problem would be to durably reduce the gate voltage of the SiC MOSFET or to use a comparably high-impedance gate resistance. These solutions have the disadvantage of increasing conduction and switching losses. In addition, there may be short-circuits cases in which a high-impedance gate resistance is not a desired option.

The problem to be solved may be seen in how to provide a gate driver circuit comprising a SiC-MOSFET which is capable of efficiently protecting the SiC-MOSFET from overcurrents in all short-circuit cases, that is during switch-on or when the device is already switched on.

### SUMMARY

The above mentioned problem is solved by arranging an additional circuit between the gate driver and the MOSFET that reduces the voltage applied to the gate electrode of the MOSFET during the switch-on of the MOSFET or when a short-circuit is detected. The short-circuit current can be controlled by the gate voltage of the MOSFET. This makes it possible to reduce short-circuit currents. The underlying idea of this solution is to only reduce the gate voltage of the MOSFET in overcurrent situations and to restore the gate voltage to a normal value in the normal on-state of the MOSFET, thus preventing conduction losses in the normal on-state.

In one example, the disclosure is directed to a gate driver circuit comprising a field-effect transistor having a gate electrode, a drain electrode, and a source electrode; a gate driver configured to provide a first voltage to the gate electrode of the field-effect transistor in accordance with an input signal; and a protection circuit coupled to the drain electrode and to the gate electrode and configured to apply a second voltage to the gate electrode when a source-drain voltage of the field-effect transistor exceeds a threshold voltage.

In one example, the disclosure is directed to a method for driving a gate of a field-effect transistor comprising the steps of: providing a first voltage to the gate electrode of the field-effect transistor in accordance with an input signal; and applying a second voltage to the gate electrode when the source-drain voltage of the field-effect transistor exceeds a threshold voltage.

### BRIEF DESCRIPTION OF THE DRAWINGS

The embodiments described herein can be better understood with reference to the following description and drawings. The components in the figures are not necessarily to scale, emphasis instead being placed upon illustrating the principles of the embodiments. Furthermore, in the figures, like reference numerals designate corresponding parts. In the drawings:
Figure 1 is a schematic diagram illustrating an example gate driver circuit, in accordance with one or more techniques described in this disclosure.
Figure 2 is a schematic diagram illustrating an alternative example gate driver circuit, in accordance with one or more techniques described in this disclosure.
Figure 3 is a timing diagram illustrating the behavior of several voltages in the example gate driver circuit of Figure 2, in accordance with one or more techniques described in this disclosure.
Figure 4 is a schematic diagram illustrating an alternative example gate driver circuit, in accordance with one or more techniques described in this disclosure.
Figure 5 is a flowchart illustrating an example method for driving a field-effect transistor, in accordance with one or more techniques described in this disclosure.

### DETAILED DESCRIPTION

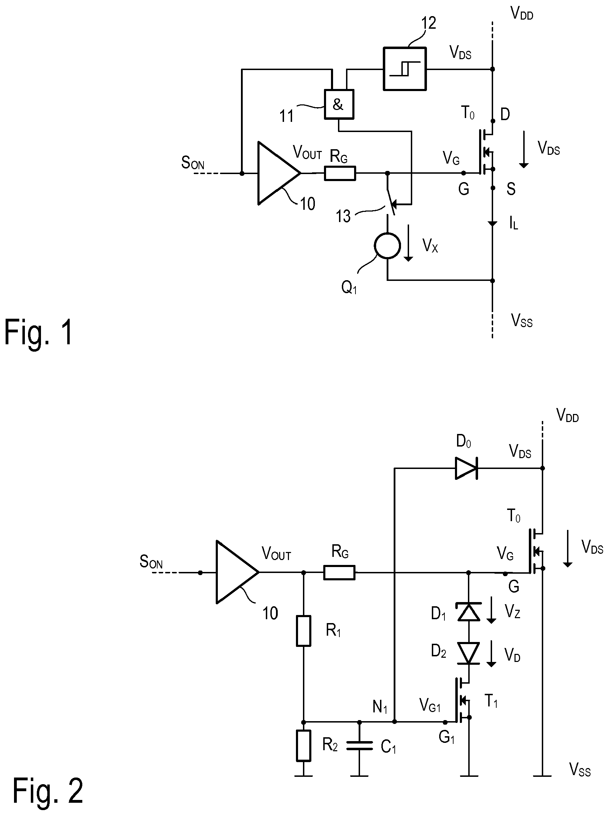

Figure 1 illustrates an exemplary embodiment of a gate driver circuit. Accordingly, the circuit comprises a gate driver 10, a MOSFET T₀, and a protection circuit. The MOSFET T₀ has a gate electrode G, a drain electrode D, and a source electrode S. A load (not shown in Fig. 1) may be coupled between the source electrode S and and a reference potential Vss (e.g. ground). The reference potential Vss may be ground (in case of a low side switch) or a floating potential (in case of a high side switch). Alternatively, the load may be connected between the drain electrode D and a supply potential V_{DD}. When the transistor T₀ is switched on, a load current I_{L} flows from the source electrode S to ground while passing through the load. In some applications, the MOSFET To may be employed as a low-side switch or a high-side switch of a half-bridge, e.g. in a three-phase bridge circuit (so-called six-pack) or a buck converter. The MOSFET T₀ may be implemented as a SiC-MOSFET. Compared to conventional MOSFETs or IGBTs, SiC-MOSFETs usually exhibit excellent switching performance with much lower conduction and switching losses in all temperature ranges. SiC-MOSFETs also have a very low on-state resistance and a low input resistance. The embodiments described herein may, however, also be used for other types of switches.

The gate driver 10 is configured to receive an input signal S_{ON} and to generate an output voltage V_{OUT} in accordance with the input signal S_{ON}, which usually is a binary signal having only two valid signal levels (i.e. a high level and a low level such as 5V and 0V). The gate driver 10 is coupled to the gate electrode G of the MOSFET via a resistor R_{G} that is usually referred to as gate resistor. The gate driver 10 is thus able to apply a gate voltage V_{G} to the gate electrode G, which has a voltage level approximately equal to the output voltage V_{OUT} (V_{G} ≈ V_{OUT}). The first voltage level of the gate voltage V_{G} is chosen high enough to be able to drive the MOSFET T₀ into a highly conductive state (low on-resistance R_{ON}) when applied at the gate electrode G. For example, the first voltage V_{OUT} may be around 15 V. The voltage level of the gate voltage VG may be around 11 V during switch-on and around 15V when the MOSFET is switched on. The gate driver 10 is thus able to switch the MOSFET T₀ on and off depending on the input signal S_{ON}.

In accordance to the depicted example, the protection circuit includes a comparator circuit 12, an AND-gate 11, an electronic switch 13, and a constant voltage source Q₁ (providing voltage V_{X}). The constant voltage source Qi may be implemented by a series of diodes or Zener diodes. The comparator circuit 12 is coupled to the drain electrode D of the MOSFET To and to a control input of switch 13 (via AND-gate 11). The switch 13 is coupled between the gate electrode G of the MOSFET To and the constant voltage source Q₁, so that the voltage V_{X} is applied, as gate voltage V_{G} (V_{G} ≈ V_{X}), between the gate electrode G and the source electrode S of the transistor To when the electronic switch 13 is closed. Thereby, the voltage V_{X} generated by voltage source Q₁ is lower than the output voltage V_{OUT} of the gate driver 10 (V_{X}<V_{OUT}). For example, the second voltage V_{X} may be equal to 11 V while V_{OUT} is 15 V.

The switch 13 is configured to switch between an on-state and an off-state. In a normal state of the gate driver circuit (steady state after switch-on of transistor T₀), the switch 13 is off. The comparator circuit 12 is configured to detect whether a drain-source voltage V_{DS} across the drain-source current path of the MOSFET T₀ exceeds a predetermined threshold voltage V_{TH}. The predetermined threshold voltage V_{TH} may be chosen so that it is higher than the drain-source voltage V_{DS} of the MOSFET T₀ in a normal on-state thereof (i.e. when V_{DS}=I_{L}·R_{ON}). When the drain-source voltage V_{DS} exceeds the threshold voltage V_{TH}, the comparator circuit 12 outputs a signal (via AND gate 11) to the switch 13 for it to switch on. The AND-gate 11 ensures that the switch 13 can only be switched on by the comparator circuit 12 when the gate driver 10 receives an input signal S_{ON} indicating a switch-on for the MOSFET T₀. Otherwise, the output signal of the comparator 12 would be blanked.

When the input signal S_{ON} received by the gate driver 10 indicates a switch-off, the MOSFET T₀ is switched off and the switch 13 is also switched off (or prevented from switching on). When the input signal S_{ON} received by the gate driver 10 indicates a switch-on, the gate driver 10 generates a corresponding output voltage V_{OUT} with a sufficiently high voltage level (e.g. 15V), which his applied (via gate resistor R_{G}) as gate voltage V_{G} to the gate electrode G of the MOSFET T₀. As mentioned, the voltage applied at the gate electrode G is approximately equal to the output voltage V_{OUT} of the gate driver 10 once the gate capacitance is fully charged and the gate current passing through the resistance R_{G} has dropped to zero. The MOSFET T₀ is then switched on and the drain-source voltage V_{DS} present between the source electrode S and the drain electrode D drops to comparably low values R_{ON}·I_{L}, e.g. 100mV or less, which are lower than the above-mentioned threshold value V_{TH}.

Dependent on the load, during the transient switching-on phase of the MOSFET T₀, very high currents may flow between the drain electrode D and the source electrode S of the MOSFET T₀, leading to a drain-source voltage V_{DS} significantly higher than the mentioned threshold value V_{TH}. The comparator circuit 12 detects such an excess drain-source voltage V_{DS} greater than the threshold value V_{TH} and generates a respective comparator output signal, which is supplied to the control input of switch 13 for it to switch on. When switching on, the switch 13 clamps the gate electrode G of the MOSFET T₀ to the voltage V_{X} of the constant gate source Q₁ via a low-ohmic current path (no resistor is present between the gate electrode G and the voltage source Q₁), thus reducing the gate voltage V_{G} to the voltage level V_{X} and, as a consequence, the on-resistance R_{ON} of the MOSFET T₀ increases causing the load current I_{L} and the power dissipation to decrease. This way, overcurrents due to the switching-on of the MOSFET T₀, which only occur during a comparably short time interval, and damages to the MOSFET T₀ can be avoided or at least reduced. The device may also comprise a back channel contact (back gate) for switching off the MOSFET.

As mentioned, when the MOSFET T₀ is conductive, the drain-source voltage V_{DS} can drop, in steady state, to be as low as approximately 100 mV or less. Since, in this "normal" on-state the drain-source voltage V_{DS} is under the predetermined voltage threshold V_{TH} of the comparator circuit 12, the comparator circuit 12 provides a comparator output signal that keeps the switch 13 off and thus that gate voltage at the higher level determined by the output voltage VOUT of the gate driver. Conduction losses are reduced as compared to the case when the lower gate voltage V_{X} is applied to the gate electrode G.

During the on-state of the MOSFET T₀, it can happen that the load is short-circuited, which leads to an overcurrent flowing through the MOSFET T₀. In such a short-circuit state the drain-source voltage V_{DS} present across the MOSFET T₀ is determined by the supply voltage (e.g. V_{DD}-V_{SS}) applied to the MOSFET T₀ causing a power dissipation of (V_{DD}-V_{SS})²/R_{ON} in the MOSFET T₀ and a corresponding short-circuit energy. During short-circuits the load current I_{L} can be around 20 times stronger than the nominal load current flowing through the MOSFET T₀ in normal on-state. These high currents are basically limited only by the on-resistance of the MOSFET T₀ and can severly damage the MOSFET T₀. The increase of the source-drain voltage V_{DS} resulting from a short circuit or an over-current can be detected by the comparator circuit 12. When the source-drain voltage V_{DS} exceeds the predetermined threshold voltage V_{TH} due to a short-circuit or an over-current, the same protection mechanism is triggered as in the case of a switching-on of the MOSFET T₀. The comparator circuit 12 outputs a signal to the switch 13 (via AND gate 11) for it to switch on, thus reducing the gate voltage V_{G} of the MOSFET T₀ to the lower voltage level V_{X}. As a consequence, the on-resistance R_{ON} of the MOSFET T₀ is increased and, consequently, the power dissipation is reduced.

The mentioned reduction of power dissipation gives other safety mechanisms more time to detect the over-current/short circuit, to react thereupon, and to trigger safety measures such as a safety switch-switch off of MOSFET T₀ by changing the level of the input signal S_{ON} to a low level.

Figure 2 illustrates an alternative example of the gate driver circuit according to Figure 1. In the depicted example, the switch 13 is implemented as a transistor denoted as transistor T₁. The transistor may be a MOSFET having a comparably low maximum blocking voltage. Fig. 2 is directed to an application, in which the MOSFET T₀ is used as a low side switch. Accordingly, the source electrode of the MOSFET T₀ is connected to ground (reference potential V_{SS}). Similarly, the source electrode of the transistor T₁ is also connected to the ground. As an alternative, the transistor T₁ may be implemented as a bipolar transistor.

In the example of Fig. 2, the constant voltage source Q₁ is implemented using a Zener diode D1 connected in series with a further diode D₂, so that the total voltage drop across the series circuit is determined by the sum of the Zener voltage V_{Z} and the forward voltage V_{D} of the further diode D₂. For example, the Zener diode D₁ may have a breakdown voltage V_{Z} of approximately 10V, wherein and the diode D₂ may have a forward voltage V_{D} of about 0.7. Thus, the voltage V_{X} can be calculated as V_{X}=V_{Z}+V_{D}. The series circuit of Zener diode D₁ and the further diode D₂ is coupled between the drain of the transistor T₁ and the gate electrode G of the MOSFET T₀. It is understood that the Zener diode may be implemented by any suitable semiconductor structure that exhibits a behavior substantially corresponding to the behavior of a Zener diode. The actual implementation may depend, however, on the technology used for manufacturing the integrated circuit. The optional diode D₂ may prevent a short-circuit when the gate driver switches off with a negative voltage.

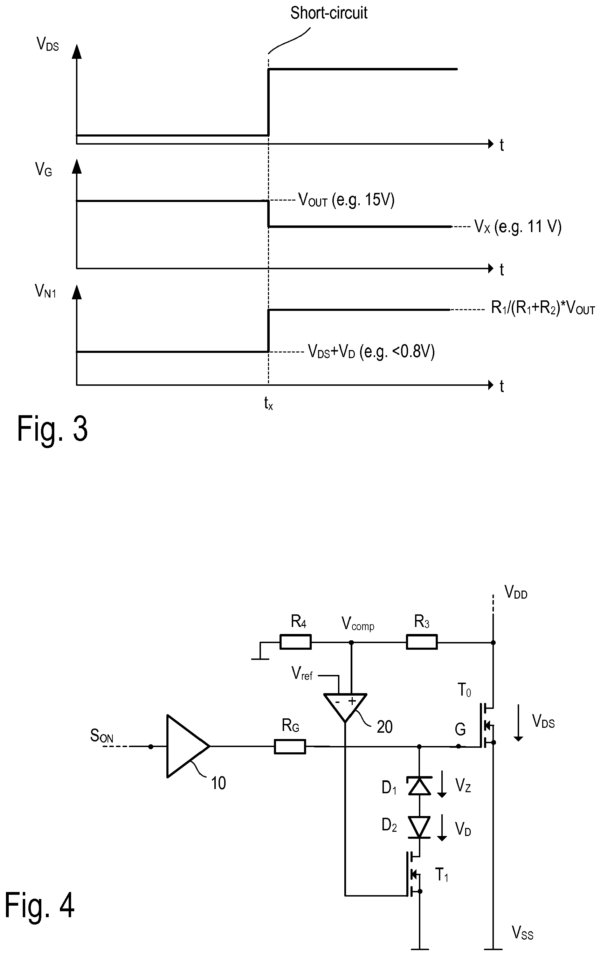

In the example of Fig. 2, the comparator circuit is implemented using a high-voltage diode D₀, a voltage divider R₁, R₂ as well as a capacitor C₁. The high-voltage diode D₀ is connected between the drain electrode D of the MOSFET T₀ and the gate electrode G₁ of the transistor T₁. The high-voltage diode D₀ is arranged such that it will be forward biased when the drain-source voltage V_{DS} is lower than the above-mentioned threshold voltage V_{TH} and reverse biased (blocking) when the drain-source voltage V_{DS} exceeds the threshold voltage V_{TH}, which basically depends on the scaling factor provided by the voltage divider as will be explained later with reference to Fig. 3. The function of the diode D₀ is thus to block the high drain-source voltage. The voltage divider R₁, R₂ is connected between an output of the gate driver 10 and ground wherein the middle tap of the voltage divider (circuit node N₁) is connected to the gate electrode Gi of the transistor T₁ so that the gate electrode G₁ "sees" the scaled driver output voltage V_{OUT}·R₂/(R₁+R₂) when the diode D₀ is blocking. The capacitor C₁ is arranged in parallel to the resistance R₂ and is thus connected between the gate electrode G₁ of the transistor T₁ and ground. The purpose of the capacitor C₁ basically forms a low pass together with resistors R₁ and R₂ and prevents false activations of the transistor T₁.

The functioning of the gate driver circuit according to Fig. 2 will now be explained with the help of the timing diagrams included in Fig. 3. Fig. 3 is a timing diagram illustrating exemplary waveforms of the drain-source voltage V_{DS} of the MOSFET T₀, the gate voltage V_{G} at the gate electrode G of the MOSFET T₀, and the gate voltage V_{N1} at the gate electrode G₁ of the transistor T₁ in the example gate driver circuit of Fig. 2 when a short-circuit occurs at the load (not shown in Fig. 2) at time instant tₓ. In a normal on-state of the MOSFET T₀ (i.e. for times t<tₓ, before the short circuit occurs), the drain-source voltage V_{DS} is in the range of a few hundreds of millivolts and basically depends on the load current I_{L} and the (very low) on-resistance R_{ON} of the MOSFET T₀.

Without a short-circuit (i.e. for times t<tₓ in Fig. 3), the diode D₀ pulls the voltage V_{N1} at circuit node N₁ below approximately 0.8 V. In this situation the voltage V_{N1} will be V_{D}+V_{DS}, wherein V_{D} is the forward voltage of diode D₀ (typically 0.6-0.7V) and V_{DS} is, as mentioned, only a few 100 mV. As a consequence, the gate G₁ of transistor T₁ is below approximately 0.8 V and thus off (assuming a transistor threshold voltage of above 0.8V for transistor T₁). In this situation (transistor T₁ off), the diodes D₁ and D₂ have no effect and the full driver output voltage V_{OUT} (e.g. 15V) is applied as gate voltage V_{G} to the MOSFET T₀.

During a short-circuit or in an over-current situation, the drain-source voltage V_{DS} of the MOSFET T₀ increases strongly, as shown at time instant tₓ in the example of Figure 3. After the time instant tₓ (i.e. for times t<tₓ) the drain-source voltage is so high that the diode D₀ is reverse biased and thus blocking. As a consequence, the voltage divider pulls the voltage V_{N1} applied to the gate of transistor T₁ up to the scaled driver output voltage V_{OUT}·R₂/(R₁+R₂) which is high enough to switch on the transistor T₁. Accordingly, the diode D₀ in connection with the voltage divider basically operates as a comparator, wherein the voltage V_{N1} can be regarded as comparator output voltage. For low drain-source voltages V_{DS}, the voltage V_{N1} will be, as explained above, below approximately 0.8 V, whereas for high drain-source voltages V_{DS} (above threshold voltage V_{DS}), the voltage V_{N1} will equal V_{OUT}·R₂/(R₁+R₂). The threshold voltage V_{TH} depends on the characteristics of the transistor T1 and can be slightly below the value V_{OUT}·R₂/(R₁+R₂) but higher than the mentioned 0.8 V. The increase of the gate voltage V_{N1} from approximately 0.8 V to V_{OUT}·R₂/(R₁+R₂), e.g. 3V, triggers a switch-on of the transistor T1, thus applying a lower gate voltage V_{X} to the gate of the MOSFET T₀, which is - in the example of Fig. 2 - dependent on the Zener voltage of diode D₁. By reducing the gate voltage V_{G} from the driver output voltage V_{OUT} to the reduced voltage V_{X}, the on-resistance R_{ON} of the MOSFET T₀ is increased and, consequently, the maximum load current I_{L} flowing through the MOSFET T₀ is reduced. As mentioned reducing the maximum load current in short-circuit situations gives external safety mechanisms more time to initiate an emergency switch-off of the MOSFET T₀. In other words, the maximum allowable short-circuit time is increased. A higher maximum short-circuit time also helps to avoid "false alarms", i.e. undesired emergency switch-off of the MOSFET T₀ in case a short-circuit is wrongly detected by the mentioned safety mechanism.

Fig. 4 illustrates another exemplary implementation of the gate driving circuit of Fig. 1, wherein the example of Fig. 4 merely distinguishes itself from the gate driver circuit of Fig. 2 by the implementation of the comparator circuit. Accordingly, the comparator circuit according to Fig. 4 comprises a comparator 20 instead of diode D₀. The output of comparator 20 is connected to the gate electrode of the transistor T₁. A voltage divider R₃, R₄ is arranged between the drain electrode of the MOSFET T₀ and ground, wherein the middle tap of the voltage divider R₃, R₄ is connected to one input of comparator 20, wherein another input of comparator 20 receives a reference voltage V_{ref}. The voltage at the middle tap of the voltage divider R₃, R₄ is denoted as V_{comp} and equals V_{DS}·R₄/(R₃+R₄).

When the voltage at the first input of the comparator 20 exceeds the reference voltage V_{ref}, the comparator 20 generates an output voltage high enough to switch-on the transistor T₁. Similarly to the previous examples, as a result, the gate electrode G of the MOSFET T₀ is clamped to the voltage *V_{X}* = *V_{Z}* + *V_{D}* of the constant voltage source formed by the Zener diode D₁ and the diode D₂. The threshold voltage V_{TH} used by the comparator effectively equals to V_{ref}·(R₃+R₄)/R₄. It is noted that the AND-gate 11 shown in the example of Fig. 1 is not needed in the examples of Figs. 2 and 4. The AND-operation is implicitly achieved as in these examples the voltage V_{X} will only be applied to the gate of MOSFET T₀ if the gate driver 10 produces a high-level output voltage. In other words, the voltage source implemented by the Zener diode D₁ can only provide a voltage V_{X} if the gate driver 10 produces a high-level output voltage V_{OUT}.

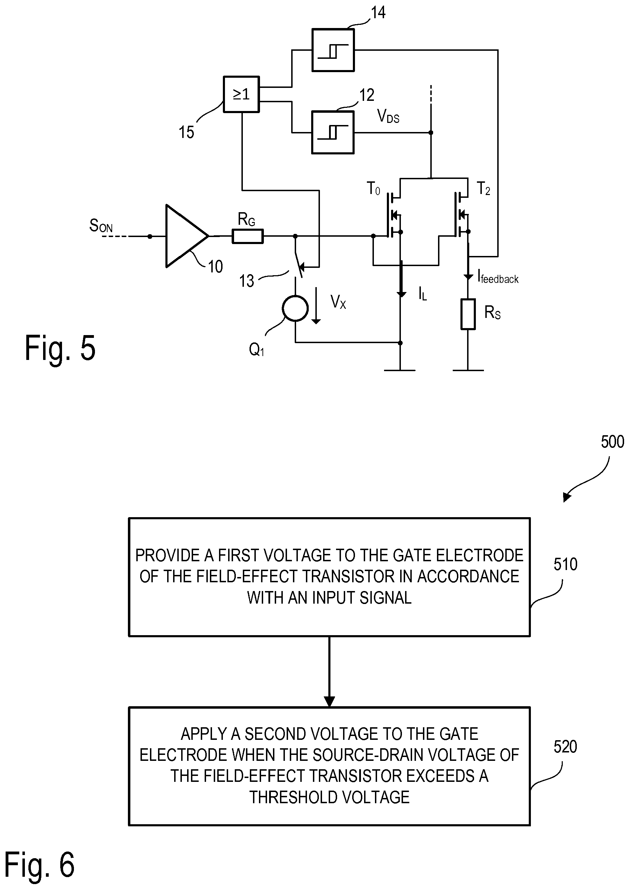

Fig. 5 illustrates another example of the gate driver circuit of Fig. 1. Basically, Fig. 5 illustrates an enhancement of the example of Fig. 1. Accordingly, the circuit of Fig. 5 basically differs from the circuit of Fig. 1 in that it the protection circuit includes a second MOSFET T₂, a second comparator circuit 14 as well as an OR-gate 15, wherein the additional circuit components are used for over-current detection.

The MOSFET T₂ is arranged in a current mirror configuration with the MOSFET T₀, which is often referred to as "SenseFET" arrangement. In the present example, this means that the drain electrodes of both MOSFETs T₀, T₂ are connected to each other and that the gate electrodes of both MOSFETs T₀, T₂ are connected to each other. A source electrode of the MOSFET T₂ is coupled to the ground via a resistor R_{S}. The current I_{feedback} flowing through the MOSFET T₂ thus approximately mirrors the current flowing through the MOSFET T₀. That is, I_{feedback}≈k·I_{L}, wherein k denotes a scaling factor lower than one. The current I_{feedback} produces a respective voltage drop V_{feedback} across the resistor R_{S}. This voltage drop V_{feedback} is representative of the load current and may be regarded as a load current measurement value.

The second comparator circuit 14 is coupled to the source electrode of the second MOSFET T₂ to receive the voltage V_{feedback} and has an output coupled to an input of the OR-gate 15. The output of comparator 12 is coupled to a second input of the OR-gate 15. An output of the OR-gate 15 is coupled to a control input of the switch 13. As compared to the example of Fig. 1, the present example of Fig. 5 allows the evaluation of a further condition to switch on the switch 13. Accordingly, switch 13 is not only switched on when the drain-source voltage V_{DS} increases above a threshold voltage V_{TH} (like in the example of Fig.1) but also when the load current i_{L} exceeds an overcurrent threshold.

When the first MOSFET T₀ is subjected to an overcurrent, the feedback current I_{feedback} and thus the voltage V_{feedback} increase strongly. When the sensed current (e.g. the voltage V_{feedback}) exceeds the mentioned overcurrent threshold, then the second comparator circuit 14 outputs a high-level signal to the control input of switch 13 via the OR-gate 15. As a consequence, the gate voltage V_{G} of the gate electrode of the first MOSFET T₀ is reduced to the voltage value V_{X} provided by the constant voltage source Q₁ as discussed with reference to Fig. 1. Similarly, when the drain-source voltage V_{DS} of the first MOSFET T₀ exceeds the threshold voltage, the first comparator circuit 12 outputs a high-level signal to switch 13 via the OR-gate 15. Again, as a result, the switch 13 is switched on. Both operations may occur in parallel, so that the switch 13 is switched on either when the source-drain voltage V_{DS} of the first MOSFET T₀ exceeds the threshold voltage or when the sense current sensed at the source electrode of the second MOSFET T₂ exceeds the overcurrent threshold. However, the rise in the sensed current may be sensed before the rise in the drain-source voltage. The circuit may be configured to switch off the MOSFET when an overcurrent is detected. The circuit according to Figure 5 provides two concurrent methods for sensing overcurrents due to a faulty operation of the MOSFET T₀, thus increasing the safety of the system by means of redundancy. Further circuits comprising the gate driver circuit of Figure 1 are also conceivable. The circuit may comprise a shunt resistor connected to the drain of the MOSFET for sensing the load current, or other known current sense circuits.

Figure 6 is a flowchart illustrating an example method for driving a field-effect transistor to increase the maximum allowable short-circuit time. The example method 500 can be employed to operate devices illustrated in this disclosure, such as the gate driving circuits according to Figures 1, 2, 4, and 5.

Method 500 includes providing a first voltage to the gate electrode G of the field-effect transistor T₀ in accordance with an input signal S_{ON}. For example, gate driver 10 can output an output voltage V_{OUT} based on an input signal S_{ON}, so that the first voltage is applied at the gate electrode G of the field-effect transistor T₀ that is sufficient to switch on the field-effect transistor T₀ with a low on-resistance R_{ON}.

Method 500 further includes applying a second voltage V_{X} as gate voltage V_{G} to the gate electrode G when the source-drain voltage V_{DS} of the field-effect transistor T₀ exceeds a threshold voltage. For example, a comparator circuit 12 can receive the drain-source voltage V_{DS} of the field-effect transistor T₀ and compare it to a threshold voltage. The comparator circuit 12 can then output a control signal to the switch 13 so that it switches on when the drain-source voltage V_{DS} exceeds the threshold voltage.

Method 500 can also include replicating a current I_{L} flowing through the field-effect transistor T₀. For example, a sense field-effect transistor T₂ arranged in a mirror configuration with the field-effect transistor T₀ can output a replicated current I_{feedback} as a proportional mirror current of the current I_{L}. Method 500 can further include sensing the replicated current I_{feedback}. For example, a comparator circuit 14 can receive a sense current derived from the replicated current I_{feedback}. Method 500 may also include applying the second voltage V_{X} to the gate electrode G of the field-effect transistor T₀ when a sense current sensed at the source electrode of the sense field-effect transistor T₂ exceeds a threshold current. For example, the comparator circuit 14 can compare the sense current to a threshold current and output a switch-on signal to the switch 13 when the sense current exceeds the threshold current.

Although various embodiments have been illustrated and described with respect to one or more specific implementations, alterations and/or modifications may be made to the illustrated examples without departing from the spirit and scope of the features and structures recited herein. With particular regard to the various functions performed by the above described components or structures (units, assemblies, devices, circuits, systems, etc.), the terms (including a reference to a "means") used to describe such components are intended to correspond - unless otherwise indicated - to any component or structure that performs the specified function of the described component (e.g., that is functionally equivalent), even if it is not structurally equivalent to the disclosed structure that performs the function in the herein illustrated exemplary implementations of the present disclosure.

## Claims

1. A gate driver circuit comprising:
a field-effect transistor (T₀) having a gate electrode (G), a drain electrode (D), and a source electrode (S);
a gate driver (10) configured to provide a first voltage (V_{OUT}) as gate voltage (V_{G}) to the gate electrode (G) of the field-effect transistor (T₀) in accordance with an input signal (S_{ON}); and
a protection circuit coupled to the drain electrode (D) and to the gate electrode (G) and configured to apply a second voltage (V_{X}) to the gate electrode (G) when a drain-source voltage (V_{DS}) of the field-effect transistor (T₀) exceeds a threshold voltage (V_{TH}).

2. The gate driver circuit according to claim 1, wherein the protection circuit comprises:
a switch coupled to the gate electrode and configured to switch between an on-state and an off-state;
a comparator circuit coupled to the drain electrode and to the switch and configured to receive the drain-source voltage and to control the switch so that it switches on the switch when the drain-source voltage exceeds a threshold voltage; and
a constant voltage source coupled to the switch and configured to provide the second voltage.

3. The gate driver circuit according to claim 2, wherein the comparator circuit comprises:
a high-voltage diode coupled to the drain electrode and to a control electrode of the switch and arranged so that it is passing when the source-drain voltage is lower than the threshold voltage and it is blocking when the source-drain voltage exceeds the threshold voltage; and
a voltage divider coupled to an output of the gate driver and to the control electrode of the switch.

4. The gate driver circuit according to claim 2, wherein the comparator circuit comprises:
a comparator coupled to the drain electrode and to the switch and configured to compare the drain-source voltage to the threshold voltage and generate a switch-on signal for the switch when the drain-source voltage exceeds the threshold voltage; and
a voltage divider arranged between the drain electrode and an input of the comparator.

5. The gate driver circuit according to one the claims 2 to 4, wherein the switch is a transistor with a low reverse voltage and the comparator circuit is coupled to the gate of the transistor.

6. The gate driver circuit according to claim 5, wherein the switch is a bipolar transistor.

7. The gate driver circuit according to one the claims 2 to 6, wherein the constant voltage source comprises a Zener diode and a polarity reversal protection diode.

8. The gate driver circuit according to one the claims 1 to 7, wherein the field-effect transistor is a SIC-MOS transistor.

9. The gate driver circuit according to one the claims 1 to 8, wherein the gate driver circuit further comprises:
a sense field-effect transistor arranged in a mirror configuration with the field-effect transistor and configured to replicate a current flowing through the field-effect transistor;
the protection circuit configured to apply the second voltage to the gate electrode when the source-drain voltage of the field-effect transistor exceeds the threshold voltage or when a sense current sensed at a source electrode of the sense field-effect transistor exceeds a threshold current.

10. Method for driving a gate of a field-effect transistor comprising the steps of:
providing a first voltage to the gate electrode of the field-effect transistor in accordance with an input signal;
applying a second voltage to the gate electrode when the source-drain voltage of the field-effect transistor exceeds a threshold voltage.

11. Method according to claim 10 further comprising the steps of:
receiving the drain-source voltage
comparing a source-drain voltage of the field-effect transistor to a threshold voltage; and
controlling a switch so that it switches on the switch when the drain-source voltage exceeds a threshold voltage.

12. Method according to one of the claims 10 or 11, further comprising the steps of:
replicating a current flowing through the power field-effect transistor;
sensing the replicated current; and
applying the second voltage to the gate electrode when a sense current sensed at a source electrode of the sense field-effect transistor exceeds a threshold current.
